# EUROPÄISCHE PATENTSCHRIFT

(11) **EP 1 925 082 B1**
(45) Veröffentlichungstag und Bekanntmachung des Hinweises auf die Patenterteilung: **30.06.2010**
(21) Anmeldenummer: 06778266.4
(22) Anmeldetag: 17.08.2006
(51) Int. Cl.: H03K 17/96, H05K 9/00

(54) **KAPAZITIVER ANNÄHERUNGSSCHALTER UND HAUSHALTSGERÄT MIT EINEM SOLCHEN**
CAPACITIVE PROXIMITY SWITCH AND DOMESTIC APPLIANCE COMPRISING THE SAME
DETECTEUR DE PROXIMITE CAPACITIF ET APPAREIL ELECTROMENAGER EQUIPE D'UN TEL DETECTEUR

(30) Priorität: 30.08.2005 DE 102005041109
(43) Veröffentlichungstag der Anmeldung: 28.05.2008
(73) Patentinhaber: BSH Bosch und Siemens Hausgeräte GmbH, 81739 München (DE)
(72) Erfinder: KLOPFER, Wilfried, 93057 Regensburg (DE)
(86) Internationale Anmeldenummer: PCT/EP2006/065412
(87) Internationale Veröffentlichungsnummer: WO 2007/025871

(56) Entgegenhaltungen:
- EP-A- 0 859 467
- EP-A- 1 416 635
- DE-U1-202005 002 157

## Beschreibung

Die Erfindung bezieht sich auf einen kapazitiven Annäherungsschalter mit einer von einer elektrisch isolierenden Abdeckplatte abgedeckten elektrisch leitenden Sensorfläche als Teil eines _ Kondensators mit durch Annäherung veränderlicher Kapazität, mit einer zugehörigen Auswerteschaltung, und mit einem elektrisch leitfähigen Körper, über den die Sensorfläche mit der Auswerteschaltung verbunden ist, und der zwischen der elektrisch isolierenden Abdeckplatte und einem in einem Abstand von dieser angeordneten Träger angeordnet ist.

Es sind bereits zahlreiche Vorrichtungen mit kapazitiven Sensoren oder Schaltern bekannt. Die vorliegende Erfindung bezieht sich auf eine spezielle Bauart von kapazitiv wirkenden Schaltern, bei der eine elektrisch leitende Sensorfläche von einer elektrisch isolierenden Abdeckplatte abgedeckt ist. Ein Benutzer berührt also die Sensorfläche nicht direkt, sondern nähert sich ihr bei Berührung der Abdeckplatte lediglich an. Die Sensorfläche bildet eine Platte eines offenen Kondensators, dessen Kapazität von dem Abstand zu einer zweiten Platte (z.B. Erde) abhängt, der beispielsweise durch Annäherung eines Fingers des Benutzers verändert wird.

Ein solcher kapazitiver Annäherungsschalter ist bereits aus EP 0 859 467 A1 bekannt. Dort ist auf einer Platine mit einer zu dem Annährungsschalter gehörenden Auswerteschaltung ein elektrisch leitfähiger Schaumstoff- bzw. Gummikörper angeordnet, der mit seinem von der Platine abgewandten Ende an der Unterseite einer in einem Abstand zu der Platine angeordneten Abdeckplatte anliegt und dort eine Sensorfläche bildet. Ein solcher Annäherungsschalter hat allerdings den Nachteil, dass er störungsanfällig selbst gegenüber kleinen Störkapazitäten ist. So können beispielsweise benachbarte Leitungen, insbesondere von Ansteuerschaltungen benachbart angeordneter Anzeigen die Auswertung der Sensorfläche durch die Auswerteschaltung empfindlich stören, so dass Fehlfunktionen des kapazitiven Annäherungsschalters auftreten.

Der vorliegenden Erfindung liegt daher die Aufgabe zugrunde, einen verbesserten, kostengünstigen kapazitiven Annäherungsschalter zur Verfügung zu stellen.

Gelöst wird die vorstehend aufgezeigte Aufgabe durch einen kapazitiven Annäherungsschalter mit den Merkmalen des Anspruchs 1. Vorteilhafte sowie bevorzugte Ausgestaltungen der Erfindung sind Gegenstand der abhängigen Ansprüche.

Bei einem kapazitiven Annäherungsschalter der eingangs genannten Art, ist eine elektrisch leitende Sensorfläche von einer elektrisch isolierenden Abdeckplatte abgedeckt und bildet nach einem bekannten Prinzip eine Fläche eines Kondensators, dessen Kapazität durch Annäherung bzw. Berührung der Abdeckplatte veränderlich ist, was mittels einer Auswerteschaltung ausgewertet werden kann. D.h. die elektrisch isolierende Abdeckplatte dient als Berühr- oder Annäherungsfläche des kapazitiven Annäherungsschalters. Zwischen der elektrisch isolierenden Abdeckplatte und einem in einem Abstand von dieser angeordneten Träger ist ein elektrisch leitfähiger Körper angeordnet, über den die Sensorfläche mit der Auswerteschaltung verbunden ist. Auf dem Träger, der insbesondere eine Leiterplatte sein kann, ist erfindungsgemäß zumindest ein elektronisches Bauelement der Auswerteschaltung derart angeordnet, dass es in einen Hohlraum ragt, der von dem elektrisch leitfähigen Körper umgeben ist. Der elektrisch leitfähige, Körper bildet eine Art Faradaykäfig für das elektronische Bauelement der Auswerteschaltung, wodurch dieses gegenüber elektromagnetischen bzw. kapazitiven Störsignalen der Umgebung abgeschirmt ist. Auf diese Weise können Fehlfunktionen des Annäherungsschalters, die ihre Ursache in den Störsignalen der Umgebung haben, deutlich reduziert werden.

Aus EP 0 859 467 A1 ist bekannt, dass in einem entlang der Längsachse eines elektrisch leitenden Kunststoffkörpers ausgebildeten Durchbruch eine LED als Anzeigeelement zur Kennzeichnung des Annäherungsschalters eingesetzt ist. Die Aufgabe der Anordnung gemäß EP 0 859 467 A1 besteht allerdings lediglich darin, durch den Kunststoffkörper Streulicht von der LED in die Umgebung zu verhindern. Eine eventuelle Abschirmwirkung des elektrisch leitfähigen Kunststoffkörpers gegenüber elektromagnetischen bzw. kapazitiven Störsignalen ist in Bezug auf das Anzeigeelement ohne Bedeutung, da im Gegensatz zu der Auswerteschaltung der Sensorfläche das Anzeigeelement mit ihrer zugehörigen Ansteuerschaltung gegenüber diesen Störsignalen unempfindlich ist.

Bekannte Auswerteschaltungen der Sensorfläche weisen ein aktives Bauelement, wie beispielsweise ein Schaltelement auf, insbesondere in Form eines Halbleiterschalters. Das aktive Bauelement hat zumindest einen Signaleingang, der mit der Sensorfläche verbunden ist. Des weiteren hat das aktive Bauelement einen Signalausgang, dessen Ausgangssignal von der Kapazität des mit der Sensorflächen gebildeten Kondensators abhängig ist und zur Bestimmung eines Betätigungszustands der kapazitiven Annäherungsschalters herangezogen wird. Dieses aktive Bauelement reagiert besonders empfindlich auf elektromagnetische bzw. kapazitive Störsignale der Umgebung. Gemäß einer bevorzugten Ausführungsform der Erfindung wird dieses aktive Bauelement der Auswerteschaltung auf dem Träger derart angeordnet, dass es in den von dem elektrisch leitfähigen Körper umgeben Hohlraum ragt, so dass es auf diese Weise von den Störsignalen abgeschirmt wird. Dies hat den Vorteil, dass eine Verfälschung des Ausgangssignal des aktiven Bauelements durch die Störsignale der Umgebung vermieden wird, wodurch sich die Zuverlässigkeit des Annäherungsschalters insgesamt verbessert.

Insbesondere können auch weitere zu dem aktiven Bauelement zugehörige elektronische Bauteile, wie beispielsweise ein Strombegrenzungswiderstand; auf dem Träger derart angeordnet sein, dass sie in den von dem elektrisch leitfähigen Körper umgebenen Hohlraum ragen. Teile der Auswerteschaltung, die weniger empfindlich auf die elektromagnetischen bzw. kapazitiven Störsignale der Umgebung reagieren, können außerhalb des von dem elektrisch leitfähigen Körpern umgebenen Hohlraums auf dem Träger oder auf einem mit dem Träger über elektrische Leiter verbundenen zweiten Träger angeordnet werden, wobei sie mit dem von dem elektrisch leitfähigen Körper umgeben Bauelement der Auswerteschaltung elektrisch verbunden sind. Diese Verbindung kann beispielsweise durch Leiterbahnen des Trägers gebildet sein.

Vorzugsweise liegt der elektrisch leitfähige Körper mit seinem der Abdeckplatte abgewandten unteren Ende an einem elektrisch leitfähigen Kontakt des Trägers an und ist über den elektrisch leitfähigen Kontakt mit der Auswerteschaltung verbunden. Der elektrisch leitfähige Körper erstreckt sich somit mit seinem unteren Ende bis zu dem Träger, so dass das auf dem Träger angeordnete Bauelement der Auswerteschaltung zusammen mit seinen auf dem Träger angeordneten elektrischen Kontakten von dem elektrisch leitfähigen Körper umgeben ist. Insbesondere ist der elektrisch leitfähige Körper über den elektrisch leitfähigen Kontakt des Trägers mit dem von ihm umgebenen Bauelement der Auswerteschaltung verbunden, so dass auch die zugehörigen Verbindungsleitungen, die insbesondere Leiterbahnen des Trägers sind, innerhalb des Hohlraums liegen, der von dem elektrisch leitfähigen Körper umgeben ist. Auf diese Weise werden auch die elektrischen Kontakte des Bauelements und die Verbindungsleitungen zu ihm von elektromagnetische Störsignalen der Umgebung abgeschirmt.

Der elektrisch leitfähige Körper ist bevorzugt derart ausgebildet, dass er ausgehend von dem Träger das in dem von ihm umgebenen Hohlraum angeordnete elektronische Bauelement über dessen gesamte Erstreckung in Richtung der Abdeckplatte umgibt. Vorteilhafterweise liegt der elektrisch leitfähige Körper mit seinem der Abdeckplatte zugewandten oberen Ende an der Unterseite der Abdeckplatte an und bildet zumindest mit einem Teil seiner Oberfläche zumindest einen Teil der Sensorfläche. Auf diese Weise befindet sich die sensorische Fühlereigenschaft des Annäherungsschalters an der Rückseite der Abdeckplatte und wird durch den elektrisch leitfähigen Körper zu dem Träger übertragen, ohne dass ein weiteres Verbindungselement notwendig ist.

Gemäß einer bevorzugten Ausführungsform ist auf der dem elektrisch leitfähigen Körper abgewandten Rückseite des Trägers zumindest im Bereich des elektrisch leitfähigen Körpers eine Abschirmfläche angeordnet. Insbesondere zusammen mit dieser Abschirmfläche bildet der elektrisch leitfähige Körper eine Art Faradaykäfig für das in ihm angeordnete elektronische Bauelement der Auswerteschaltung, so dass dieses gegenüber elektromagnetischen Störsignalen der Umgebung abgeschirmt ist. Insbesondere ist die gesamte Rückseite des Trägers als Abschirmfläche ausgebildet: Auf diese Weise kann das elektronische Bauelement auch gegenüber rückwärtig angeordneter Leistungselektronik abgeschirmt werden. Vorzugsweise bildet die Abschirmfläche eine aktive Abschirmung, indem die Abschirmfläche und die Sensorfläche zeitgleich mit einem möglichst identischen bzw. gleichen Taktsignal versorgt werden. Dies bringt den Vorteil mit sich, dass es zwischen der Sensorfläche und der Abschirmfläche zu keinem Potenzialuntersehied, damit zu keiner Ladungsverschiebung und somit zu keiner kapazitiven Beeinflussung der Sensorfläche kommt. Dies ist insbesondere bei Kapazitäten des mit der Sensorfläche gebildeten Kondensators in der Größenordnung von Piko-Farad wichtig, da in diesem Bereich selbst kleine Störkapazitäten von beispielsweise Leitungen, benachbarten Sensorflächen oder Metallgehäusen eine Messung der Kapazität des Kondensators beeinflussen. Durch eine Minimierung des Einflusses dieser Störkapazitäten auf die Sensorfläche mit Hilfe der aktiven Abschirmung ist es möglich, den Annäherungsschalter in der Nähe von metallischen Gehäuseteilen anzuordnen, selbst wenn diese geerdet sind. Da neben der Sensorfläche auch das von dem elektrisch leitfähigen Körper umgebene elektronische Bauelement der Auswerteschaltung durch die aktive Abschirmung gegenüber Störkapazitäten abgeschirmt ist, können Kapazitätsänderungen des mit der Sensorfläche gebildeten Kondensators zuverlässig ausgewertet werden, da die Kapazitätsänderung nicht durch Störsignale der Umgebung verfälscht werden kann.

Gemäß einer bevorzugten Ausführungsform ist der elektrisch leitfähige Körper eine aus einem gestreckten Körper gewundene Druckfeder, wobei der gestreckte Körper bevorzugt ein Federdraht mit rundem oder rechteckigem Querschnitt ist, aus dem auf einfache Weise die Druckfeder gewickelt werden kann. Durch diese Druckfeder können unterschiedliche Abstände zwischen der Abdeckplatte und dem Träger überbrückt werden, indem die Druckfeder unterschiedlich stark zusammengedrückt wird. Durch die hohe Leitfähigkeit des metallischen Federdrahtes können elektromagnetische Störfelder besonders gut abgeschirmt werden.

Vorzugsweise ist die Druckfeder an ihrem dem Träger zugewandten Ende zumindest in einem Teilbereich zylindrisch geformt. Dadurch kann über die gesamte, zur Druckfeder koaxiale Erstreckung des von der Druckfeder umgebenen elektronischen Bauelements der Auswerteschaltung eine gleichmäßige Abschirmung gegenüber elektromagnetischen Störsignalen der Umgebung erzielt werden. Zusätzlich wird auf diese Weise auch bei vollständig zusammengedrückter Druckfeder verhindert, dass es zu einem Berührungskontakt zwischen Windungen der Druckfeder und dem innerhalb der Druckfeder angeordneten elektronischen Bauelement kommt.

Besonders vorteilhaft ist die Druckfeder anschließend an den zylindrischen Teilbereich an seinem dem Träger abgewandten Ende einen kegelig geformten Teilbereich aufweist, so dass ein auf diese Weise erzielter Federweg der Druckfeder gegenüber einer rein zylindrischen Druckfeder erhöht ist. Vorzugsweise nimmt der Windungsdurchmesser ausgehend von dem zylindrischen Teilbereich in Richtung zur Abdeckplatte ab, so dass das innerhalb der Druckfeder angeordnete Bauelement auch von elektromagnetischen bzw. kapazitiven Störsignalen aus Richtung der Abdeckplatte abgeschirmt ist.

In einer alternativen Ausführungsform ist der elektrisch leitfähige Körper ein in sich elastischer Hohlkörper, insbesondere aus einem leitfähigen Kunststoff. Dieser elektrisch leitfähige Kunststoffkörper weist insbesondere einen zentralen Durchbruch auf, der sich axial in der Richtung von dem Träger zu der Abdeckplatte durch den gesamten Kunststoffkörper erstreckt. Das elektronische Bauelement der Auswerteschaltung ist auf dem Träger derart angeordnet, dass es in diesen Durchbruch ragt und von dem Kunststoffkörper umgeben und von Störsignalen abgeschirmt ist.

Vorteilhafterweise ist auf dem Träger in den von dem elektrisch leitfähigen Körper umgebenen Hohlraum ragend und/oder innerhalb eines durch die Sensorfläche definierten Bereichs ein Leuchtelement angeordnet, wie beispielsweise eine LED, eine Glühlampe oder ein Lichtleiter. Dieses Leuchtelement kann zur Kennzeichnung der Sensorfläche oder zur Signalisierung verschiedener Schaltzustände des Annäherungsschalters dienen. Weiterhin kann zur Positionskennzeichnung der Sensorfläche an der Oberseite der Abdeckplatte oder bei durchsichtiger Abdeckplatte an deren Unterseite eine Markierung, z.B. in Form eines Aufdrucks angebracht sein.

Vorzugsweise ist ein Haushaltsgerät, wie beispielsweise eine Waschmaschine, ein Wäschetrockner, eine Geschirrspülmaschine, ein Gargerät, eine Dunstabzugshaube, ein Kältegerät, ein Klimagerät, ein Warmwasserbereiter oder ein Staubsauger, bzw. ein Eingabefeld für ein Haushaltsgerät mit zumindest einem erfindungsgemäßen Annäherungsschalter ausgestattet. Somit kann das Haushaltsgerät mit einer das Eingabefeld umfassenden durchgängige Blende ausgestattet werden, so dass das Haushaltsgerät gegenüber einem Eintritt von Verschmutzungen oder Feuchtigkeit geschützt ist. Die Blende entspricht dabei der elektrisch isolierenden Abdeckplatte und kann beispielsweise aus Glas, Glaskeramik, Keramik, Kunststoff, Holz oder Stein gefertigt sein.

Es wird darauf hingewiesen, dass die Merkmale der Unteransprüche ohne Abweichung von der erfindungsgemäßen Idee in beliebiger Weise miteinander kombinierbar sind.

Anhand von Zeichnungen wird die Erfindung nachstehend näher erläutert.
- Fig. 1: zeigt in einer schematischen Schnittansicht einen Ausschnitt eines Haushaltagerätes mit einer Blende, die ein erfindungsgemäßes Eingabefeld aufweist,
- Fig.2: zeigt in einer schematischen Vorderansicht eine Ausführungsform einer Sensorfläche mit einer die Sensorfläche umrahmenden Abschirmfläche,
- Fig. 3a, 3b: zeigen schematisch einen Ausschnitt des Eingabefeldes gemäß Figur 1 mit einer Betätigung eines erfindungsgemäßen kapazitiven Annäherungssensors durch einen Benutzer,
- Fig. 4: zeigt einen Ausschnitt eines schematischen elektrischen Schaltkreises des erfindungsgemäßen kapazitiven Annäherungsschalters,
- Fig. 5: zeigt einen Ausschnitt eines schematischen elektrischen Schaltkreises des erfindungsgemäßen Annäherungsschalters mit einer aktiven Abschirmung,
- Fig. 6: zeigt einen schematischen Schaltkreis des Eingabefeldes gemäß Fig. 1 mit mehreren in einer Matrixform verschalteten erfindungsgemäßen Annäherungsschalter,
- Fig.7: zeigt in einer schematischen Vorderansicht eine Ausführungsform zweier Sensorflächen, die einen Positionssensor bilden,
- Fig. 8: zeigt in einer schematischen Schnittansicht einen Ausschnitt des Eingabefeldes gemäß Figur 1 mit elektronischen Bauelementen des elektrischen Schaltkreises gemäß Figur 4, die in einen von einer Druckfeder umgeben Hohlraum ragen.

Bevor auf die Zeichnungen näher eingegangen wird, sei angemerkt, dass einander entsprechende oder gleiche Elemente bzw. Einzelteile bei den verschiedenen Ausführungsformen des kapazitiven Annäherungsschalters gemäß der Erfindung in sämtlichen Zeichnungsfiguren durch gleiche Bezugszeichen bezeichnet sind. Werden in einer Zeichnung mehrere Elemente bzw. Einzelteile gleicher Art verwendet, auf die unterschiedlich Bezug genommen wird, so wird für die führende(n) Stelle(n) der entsprechenden Bezugszeichen jeweils die gleiche(n) Ziffer(n) gewählt. Die folgenden Stellen der entsprechenden Bezugszeichen dienen dazu, die Elemente bzw. Einzelteile gleicher Art zu unterscheiden.

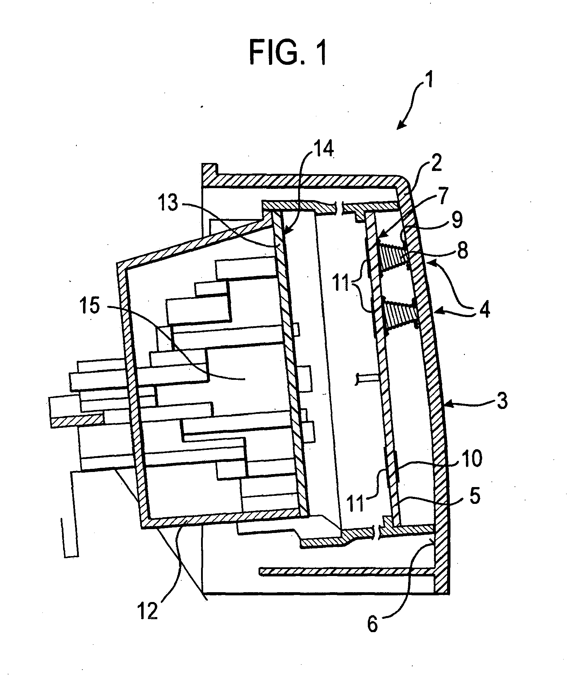

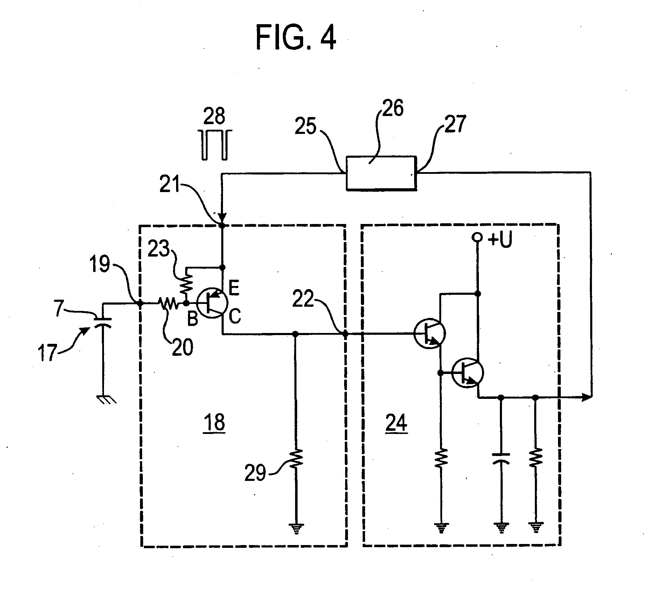

In Fig. 1 ist in einer schematischen Schnittansicht ein Ausschnitt eines Haushaltsgerätes 1 mit einer Blende 2 gezeigt, die ein erfindungsgemäßes Eingabefeld 3 aufweist. Die Blende 2 ist als elektrisch isolierende Abdeckplatte aus einem Dielektrikum, wie beispielsweise Glas, Glaskeramik, Keramik, Kunststoff, Holz oder Stein ausgebildet. Das Eingabefeld 3 enthält mehrere baugleiche kapazitive Annäherungsschalter 4, von denen hier nur zwei gezeigt sind und von denen im folgenden lediglich einer beschrieben wird. In einem Abstand von der Blende 2 ist eine Leiterplatte 5 mit einer der Rückseite 6 der Blende 2 zugewandten elektrisch leitfähigen Sensorfläche 7 angeordnet. Die Leiterplatte 5 kann eine Kunststoffplatte sein, die auf wenigstens einer ihrer Plattenseiten die erwähnte Sensorfläche 7 und gegebenenfalls Leiterbahnen aufweist, über die die Sensorfläche 7 mit einem elektrischen Schaltkreis 14 des Annäherungsschalters 4 (siehe Fig. 4, 5 und 6) elektrisch leitend verbunden ist. Die elektrisch leitende Schicht der Sensorfläche 7 kann in verschiedenen Formen ausgebildet sein, beispielsweise rund oder eckig, vollflächig, gitterförmig oder rahmenförmig.

Zwischen der Blende 2 und der Leiterplatte 5 ist ein elektrisch leitfähiger Körper in Form einer gewundene Druckfeder 8 angeordnet, die vorzugsweise aus Federdraht ausgebildet ist. Die Druckfeder 8 weist an ihrem oberen Ende einen flachen Windungsteller 9 auf, der aus mehrere Windungen besteht, die aufgrund einer Druckspannung, unter der die Druckfeder 8 steht, spiralförmig ineinander liegen und formschlüssig an die leicht gewölbte Form der Rückseite 6 der Blende 2 angepasst sind. Die Druckfeder 8 weist an ihrem unteren Ende eine untere Windung 9' auf, mit der sie an der Sensorfläche 7 der Leiterplatte 5 plan anliegt und dort mit der Sensorfläche 7 der Leiterplatte 5 beispielsweise verlötet oder verklebt ist, oder mit der sie an der Sensorfläche 7 der Leiterplatte 5 lediglich unter Druckspannung fest anliegt, so dass eine elektrisch leitende Verbindung zwischen der Druckfeder 8 und der Sensorfläche 7 der Leiterplatte 5 besteht. Durch diese elektrisch leitende Verbindung ist die sensorische Fühlereigenschaft der Sensorfläche 7 von der Leiterplatte 5 an die Rückseite 6 der Blende 2 verlagert und die Druckfeder 8 bildet nun ihrerseits zumindest einen Teil der Sensorfläche 7, insbesondere mit ihrem Windungsteller 9, 9'. Anstatt als gewundene, metallische Druckfeder 8 kann der elektrisch leitfähige Körper auch andere Formen aufweisen, wie beispielsweise zylinder- , kegel- oder quaderförmig, und/oder aus anderen, elektrisch leitfähigen Materialien ausgebildet sein, wie beispielsweise aus einem elektrisch leitfähigen Kunststoff oder aus einem Kunststoff mit metallischer Seele.

Auf der gleichen Seite der Leiterplatte 5, auf der sich die Sensorfläche 7 befindet, also auf der der Rückseite 6 der Blende 2 zugewandten Vorderseite der Leiterplatte 5, ist eine elektrisch leitfähigen Referenzsensorfläche 10 angeordnet. Die Referenzsensorfläche 10 ist analog zu der Sensorfläche 7 mit dem Schaltkreis 14 des Annäherungsschalters 4 elektrisch leitend verbunden. Es kann für jede der Sensorflächen 7 eine zugehörige Referenzsensorfläche 10 oder für mehrere oder alle der Sensorflächen 7 eine gemeinsame Referenzsensorfläche 10 vorgesehen sein. Im Unterschied zu der Sensorfläche 7 fehlt bei der Referenzsensorfläche 10 die elektrisch leitfähige Druckfeder 8, so dass die Referenzsensorfläche 10 durch die Luftschicht zwischen der Leiterplatte 5 und der Blende 2 gegenüber elektrischen Ladungen bzw. Ladungsänderungen an der Vorderseite der Blende 2 elektrisch isoliert ist.

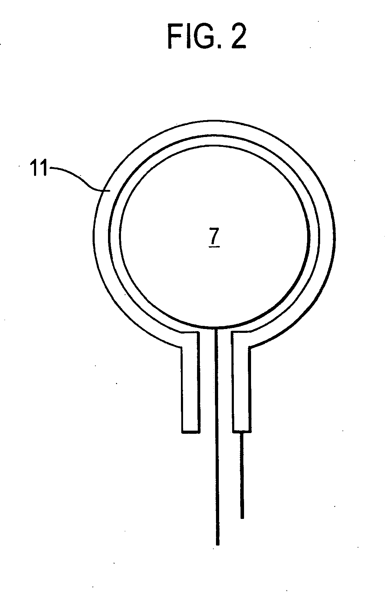

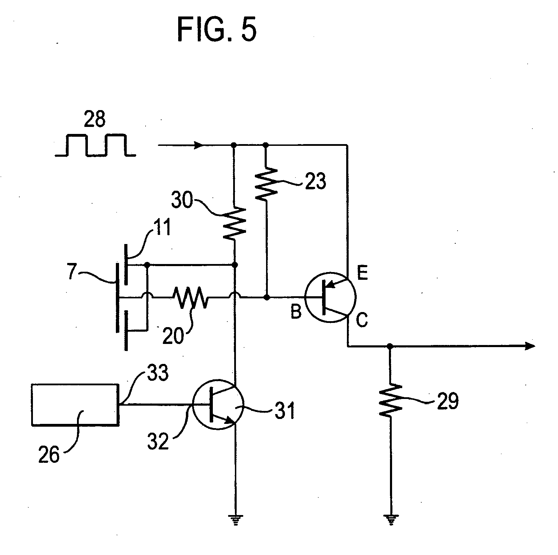

Auf der Rückseite der Leiterplatte 5 ist an der Position der Sensorfläche 7 bzw. der Referenzsensorfläche 10 jeweils eine elektrisch leitende Abschirmfläche 11 angeordnet, deren Funktionsweise weiter unten in Figur 5 beschrieben wird. Anstelle von einzelnen Abschirmflächen 11 je Sensorfläche 7 bzw. Referenzsensorfläche 10 kann eine einzige Abschirmfläche vorgesehen sein, die sich über die gesamte Rückseite der Leiterplatte 5 erstreckt oder die zumindest auf der Rückseite der Leiterplatte 5 den Bereich abdeckt, der die Sensorflächen 7 bzw. die Referenzsensorfläche 10 umfasst. Insbesondere kann die Leiterplatte 5 eine flexible Leiterplatte oder eine kupferkaschierte Kunststofffolie sein. In einer weiteren alternative Ausführungsform, die in Figur 2 gezeigt ist, befinden sich die Sensorfläche 7, die hier rund ausgeführt ist, und die Abschirmfläche 11 beide auf der Vorderseite der Leiterplatte 5. Die Abschirmfläche 11 wird hier durch einen elektrisch leitfähige Schicht gebildet, die die Sensorfläche 7 rahmenförmig umgibt, wobei die Form dieses Rahmens der Außenkontur der Sensorfläche 7 angepasst ist.

Der elektrische Schaltkreis 14 des Annäherungsschalters 4 kann auf der Vorder- oder Rückseite der Leiterplatte 5 oder auf einer separaten Platine angeordnet sein. Des weiteren kann für mehrere oder alle Annäherungsschalter 4 ein gemeinsamer Schaltkreis 14 vorgesehen sein. In der in Figur 1 gezeigten Ausführungsform ist im rückwärtigen Bereich der Leiterplatte 5 ein Elektronikmodul 12 angeordnet, das eine Platine 13 aufweist, die auf ihrer der Leiterplatte 5 zugewandten Vorderseite den Schaltkreis 14 des Annäherungsschalters 4 aufweist und die auf ihrer Rückseite mit Leistungselektronik 15 des Haushaltsgerätes 1 bestückt ist. Diese Platine 13 ist mit der Leiterplatte 5 elektrisch leitend verbunden (nicht gezeigt).

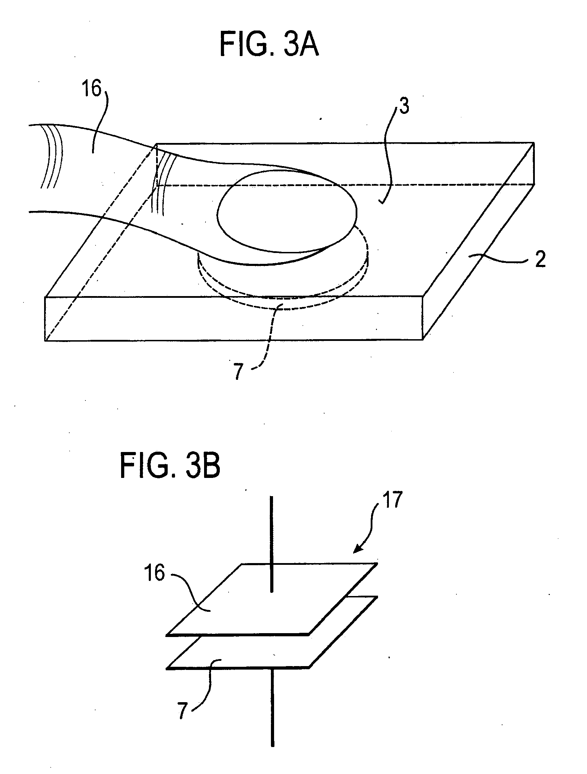

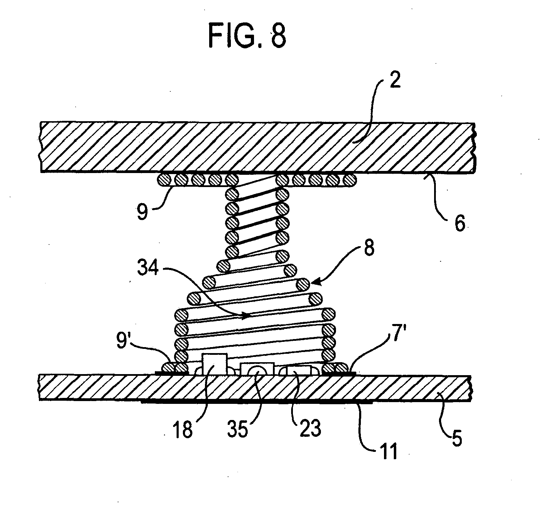

Wird nun wie in Figur 3a gezeigt ein Element, wie beispielsweise ein Finger 16 eines Benutzers, das bzw. der ein vom Potenzial der Sensorfläche 7 verschiedenes Potenzial, insbesondere Erdpotenzial führt, an einen der Sensorfläche 7 gegenüberliegenden Oberflächenbereich der Blende 2 angenähert und/oder mit diesem in Berührung gebracht, so wird dadurch eine Kapazitätsänderung eines aus dem betreffenden Element bzw. dem Finger 16, der Blende 2 und der Sensorfläche 7 bzw. der Sensorfläche 7 zusammen mit der Druckfeder 8 bestehenden Kondensators 17 hervorgerufen (vgl. Fig. 3b). Da die Sensorfläche 7 elektrisch leitend mit dem Schaltkreis 14 des Annäherungsschalters 4 verbunden ist, kann die Kapazitätsänderung durch den Schaltkreis 14 festgestellt und zur Auslösung eines Schaltsignals weiter ausgewertet werden, wie weiter unten beschrieben. Des weiteren kann auf der Leiterplatte 5 im Bereich innerhalb der Druckfeder 8 eine Lichtquelle 35 (vgl. Fig. 8), wie beispielsweise eine LED, vorgesehen sein, um die Sensorfläche 7 zu kennzeichnen oder unterschiedliche Schaltzustände des Annäherungsschalters 4 zu signalisieren.

In Figur 4 ist ein Ausschnitt eines Schaltbildes des elektrischen Schaltkreises 14 gezeigt. Der Schaltkreis 14 weist als Halbleiterschalter 18 einen PNP-Bipolartransistor auf, mit dessen Steuereingang 19, also mit dessen Basis, die Sensorfläche 7 über einen Strombegrenzungswiderstand 20 verbunden ist. Der Halbleiterschalter 18 weist darüber hinaus einen Signaleingang 21, d.h. den Emitter des PNP-Bipolartransistors, und einen Signalausgang 22, d.h. den Kollektor des PNP-Bipolartransistors, auf, wobei der Signaleingang 21 über einen Basis-Emitter-Widerstand 23 mit der Sensorfläche 7 verbunden ist. Der Strombegrenzungswiderstand 20 und der Basis-Emitter-Widerstand 23 können in dem PNP-Bipolartransistor bereits integriert ausgeführt sein. Der Signalausgang 22 des Halbleiterschalters 18 ist zur weiteren Verarbeitung eines Ausgangssignals mit einer Sample and Hold-Stufe 24 bekannter Art verbunden, durch die ein Gleichspannungssignal proportional zur Amplitude der Impulsspitzen des Ausgangssignals zur Verfügung gestellt werden kann und die hier nicht weiter beschrieben wird. Alternativ zu der Sample and Hold-Stufe 24 kann der Signalausgang 22 des Halbleiterschalters 18 zu Verarbeitung des Ausgangssignals mit einer bekannten Integratorschaltung oder einem bekannten Spitzenspannungsmesser verbunden sein (nicht gezeigt). Der Signaleingang 21 des Halbleiterschalters 18 ist mit einem analogen Signalausgang 25 eines Mikroprozessors 26 und der Signalausgang 22 des Halbleiterschalters 18 ist über die Sample and Hold-Stufe 24 mit einem analogen Signaleingang 27 des Mikroprozessors 26 verbunden. Anstelle des einen Mikroprozessors 26 können auch zwei verschiedene Mikroprozessoren verwendet werden, von denen einer mit dem Signaleingang 21 des Halbleiterschalters 18 und der andere mit dem Signalausgang 22 des Halbleiterschalters 18 verbunden ist. Anstelle des PNP-Bipolartransistors können auch andere Halbleiterschalter 18 verwendet werden, wie beispielsweise ein NPN-Bipolartransistor, Feldeffekttransistoren oder allgemein alle steuerbaren Halbleiterelemente.

An dem Signaleingang 21 des Halbleiterschalters 18 liegt ein Taktsignal 28 an, welches beispielsweise von dem analogen Signalausgang 25 des Mikroprozessors 26 zur Verfügung gestellt wird. Das Taktsignal 28 ist ein rechteckförmiges, periodisches Spannungssignal, welches von dem Mikroprozessor 26 regelmäßig zwischen Massepotenzial, d.h. LOW-Pegel, und Betriebsspannung des Schaltkreises 14 des Annäherungsschalters 4, d.h. HIGH-Pegel, umgeschaltet wird, wobei das Massepotenzial von dem Erdpotenzial des Benutzers verschieden sein kann. Die Taktfrequenz des Taktsignals 28 liegt bevorzugt im Bereich zwischen 10 und 100 Kilohertz. Der Signalausgang 22 des Halbleiterschalters 18, also der Kollektor des PNP-Bipolartransistors, liegt über einen weiteren Widerstand 29 auf dem Bezugspotenzial der Sample and Hold-Stufe 24. Mit dem LOW-Pegel des Taktsignals 28 wird der Signaleingang 21 des Halbleiterschalters 18 und damit der Emitter E des PNP-Bipolartransistors sowie der Basis-Emitter-Widerstand 23 auf Massepotenzial gelegt. Dies führt dazu, dass die Sensorfläche 7 bzw. der Kondensator 17 über den Strombegrenzungswiderstand 20 und den Basis-Emitter-Widerstand 23 entladen wird. Dadurch wird die Basis B des PNP-Bipolartransistors gegenüber dem Emitter E des PNP-Bipolartransistors positiv und der PNP-Bipolartransistors sperrt. Mit dem auf den LOW-Pegel folgenden HIGH-Pegel des Taktsignals 28 wird die Sensorfläche 7 und damit der Kondensator 17 über den Basis-Emitterwiderstand 23 und den Strombegrenzungswiderstand 20 aufgeladen. Während dieser Aufladezeit der Sensorfläche 7 bzw. des Kondensators 17 besteht ein Spannungsabfall an dem Basis-Emitter-Widerstand 23. Dadurch wird die Basis B des PNP-Bipolartransistors gegenüber dem Emitter E negativ und der PNP-Bipolartransistor wird leitend und schaltet so lange durch, bis die Sensorfläche 7 bzw. der Kondensator 17 auf den HIGH-Pegel des Taktsignals 28 aufgeladen ist. An dem Widerstand 29 liegt während dieses Aufladezeitraums der Sensorfläche 7 bzw. des Kondensators 17 durch das Taktsignal 28 ein Ausgangssignal an, das proportional zu der Kapazität der Sensorfläche 7 bzw. des Kondensators 17 ist. Somit liegt an dem Signalausgang 22 des Halbleiterschalters 18 ein Ausgangsignal an, welches dem Taktsignal 28 folgt, und dessen Signalanteile proportional zu der Kapazität der Sensorfläche 7 bzw. des Kondensators 17 sind.

Dieses Ausgangssignal wird mittels der Sample and Hold-Stufe in ein Gleichspannungssignal umgewandelt und liegt an dem analogen Signaleingang 27 des Mikroprozessors 26 an. Der Mikroprozessor 26 ist zur Auswertung einer zeitlichen Änderung von Signalanteilen des Gleichspannungssignals und damit des Ausgangssignals beispielsweise mit Hilfe eines Software-Programms ausgebildet. Abhängig davon, wie schnell die Signalanteile des Ausgangssignals, wie beispielsweise die Höhe der Impulsspitze oder die Impulsbreite, von aufeinander folgenden Taktperioden sich ändern, wird von dem Mikroprozessor 26 eine Betätigung des Annäherungsschalters 4 erkannt. D.h. ändern sich die Signalanteile innerhalb eines vorgegebenen Zeitraums von beispielsweise einer Sekunde, so wird dies als Betätigung erkannt, ändern sich die Signalanteile langsamer, so liegt keine Betätigung vor. Auf diese Weise ist die Bestimmung einer Betätigung des Annäherungsschalters 4 unabhängig von der absoluten Größe des Ausgangssignals, wodurch dessen langfristige Änderungen, z.B. durch Alterungsprozesse, eliminiert sind.

In Figur 5 ist ein Ausschnitt des elektrischen Schaltkreises 14 des erfindungsgemäßen Annäherungsschalters 4 mit einer aktiven Abschirmung gezeigt. Die aktive Abschirmung ist durch die Abschirmfläche 11 gebildet, die über einen niederohmigen Widerstand 30 mit dem Signaleingang 21 des Halbleiterschalters 18 verbunden ist, und an der zeitgleich zu der Sensorfläche 7 das Taktsignal 28 über diesen niederohmigen Widerstand 30 anliegt. Durch geeignete Wahl des niederohmigen Widerstands 30 kann die Signalform des Taktsignals 28 an der Abschirmfläche 11 an die Signalform des Taktsignals 28 an der Sensorfläche 7 angeglichen werden, so dass kein Potenzialunterschied und damit keine Verschiebung von Ladungsträgern zwischen der Abschirmfläche 11 und der Sensorfläche 7 auftritt und somit die Abschirmung der Sensorfläche 7 durch die Abschirmfläche 11 gegenüber Störkapazitäten gewährleistet ist.

Die Abschirmfläche 11 ist zum Anlegen von Massepotenzial über einen Schalter 31, der in der hier gezeigten Ausführungsform ein NPN-Bipolartransistor ist, mit Masse verbunden. Der Schalter 31 weist einen Steuersignaleingang 32 auf, nämlich die Basis des NPN-Bipolartransistors, der mit einem Steuersignalausgang 33 des Mikroprozessors 26 verbunden ist. Somit kann der Schalter 31 bzw. der NPN-Bipolartransistor auf einfache Weise durch ein Software-Programm des Mikroprozessors 26 geschaltet werden. Zur Funktionsprüfung des Annäherungsschalters 4, d.h. zur Ermittlung eines Referenzwertes des Ausgangssignals wird die Abschirmfläche 11 durch den Schalter 31 zeitweise mit Massepotenzial verbunden, wodurch die aktive Abschirmung zeitweise außer Kraft gesetzt und eine Betätigung des Annäherungsschalters 4 simuliert wird. Auf diese Weise kann überprüft werden, ob ein ausreichender Signalhub des Ausgangssignals bei Betätigung des Annäherungsschalters 4 vorliegt, oder ob eventuell aufgrund von Verunreinigungen oder Benetzung der Blende 2, aufgrund von Umgebungsbedingungen, wie Temperatur und Feuchtigkeit, oder aufgrund von Alterungsprozessen des Annäherungsschalters 4 eine Fehlfunktion vorliegt. Eventuell kann der Signalhub des Ausgangssignals durch Änderung der Höhe des Taktsignals 28 dynamisch angepasst werden, d.h. der Annäherungsschalter 4 kann automatisch kalibriert werden, wodurch die Funktionssicherheit des Annäherungsschalters 4 verbessert wird. Wenn aufgrund beispielsweise einer verschmutzten Blende 2 eine sichere Funktion des Annäherungsschalters nicht mehr gewährleistet ist, wird das Haushaltsgerät 1 automatisch abgeschaltet.

Die Referenzsensorfläche 10 ist entsprechend der Sensorfläche 7 verschaltet. Die Referenzsensorfläche 10 ist benachbart zu der Sensorfläche 7 angeordnet, so dass die Kapazität der Referenzsensorfläche 10 bzw. eines mit der Referenzsensorfläche 10 gebildeten offenen Referenzkondensators ein Maß für die Umgebungsbedingungen, d.h. die Störkapazitäten, der Sensorfläche 7, aber auch ein Maß für den Einfluss von Temperatur, Feuchtigkeit oder von Materialveränderungen durch Alterung auf das Ausgangssignal ist. An der Referenzsensorfläche 10 liegt das gleiche Taktsignal 28 wie an der Sensorfläche 7 an, insbesondere in einem zeitlichen Multiplexverfahren. D.h. die Sensorfläche 7 und die Referenzsensorfläche 10 werden nacheinander mit verschiedene Perioden des gleichen Taktsignals 28 versorgt. Alternativ dazu kann an die Referenzsensorfläche 10 auch ein weiteres Taktsignal von einem weiteren analogen Signalausgang des Mikroprozessors 26 angelegt werden. Das von der Referenzsensorfläche 10 erzeugte Referenzsignal wird bei der Auswertung des von der Sensorfläche 7 erzeugten Ausgangssignals in dem Mikroprozessor 26 als Grundpegel des Ausgangssignals berücksichtigt, und dient somit der Bestimmung eines Betätigungszustands des Annäherungsschalters 4. Bei Haushaltsgeräten 1, die mit einem Netzschalter eingeschaltet werden, wird mit Hilfe des Referenzsignal bereits beim Einschalten festgestellt, ob eine Betätigung des Annäherungsschalters 4 vorliegt.

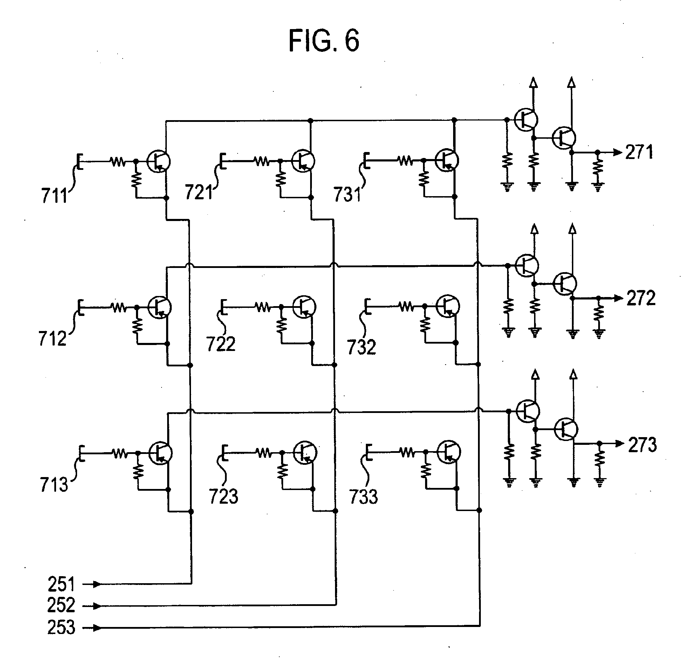

In Figur 6 ist ein schematischer Schaltkreis 14 des Eingabefeldes 3 mit neun in einer drei-mal-drei-Matrixform geschalteten erfindungsgemäßen Annäherungsschalter 4 zum Betreiben in einem zeitlichen Multiplexverfahren gezeigt. Die Sensorflächen 711, 712, 713 der ersten drei Annäherungsschalter sind mit einem ersten Signalausgang 251 des Mikroprozessors 26 verbunden. Die Sensorflächen 721, 722 und 723 der zweiten drei Annäherungsschalter sind mit einem zweiten Signalausgang 252 des Mikroprozessors 26 verbunden. Die Sensorflächen 731, 732 und 733 der dritten drei Annäherungsschalter sind mit einem dritten Signalausgang 253 des Mikroprozessors 26 verbunden. Die Sensorflächen 711, 721 und 731 sind über ihren jeweils zugehörigen Halbleiterschalter und eine erste Sample and Hold-Stufe mit einem ersten Signaleingang 271 des Mikroprozessors 26 verbunden. Die Sensorflächen 712, 722 und 732 sind über ihren jeweils zugehörigen Halbleiterschalter und eine zweite Sample and Hold-Stufe mit einem zweiten Signaleingang 272 des Mikroprozessors 26 verbunden. Die Sensorflächen 713, 723 und 733 sind über ihren jeweils zugehörigen Halbleiterschalter und eine dritte Sample and Hold-Stufe mit einem dritten Signaleingang 273 des Mikroprozessors 26 verbunden.

Das Taktsignal 28 wird jeweils für eine vorgegebene Zeitdauer, d.h. für eine vorgegebene Anzahl an Taktperioden, von einem der drei Signalausgängen 251, 252 und 253 des Mikroprozessors 26 ausgegeben. Dabei wechseln sich die Signalausgänge 251, 252 und 253 nacheinander ab, was zyklisch wiederholt wird. In der Zeitdauer, in der das Taktsignal 28 von einem der drei Signalausgänge 251, 252 und 253 ausgegeben wird, werden jeweils alle drei Signaleingänge 271, 272 und 273 des Mikroprozessors 26 ausgewertet. Auf diese Weise können mit nur einem Schaltkreis nacheinander alle neun Sensorflächen 711, 712, 713, 721, 722, 723 731, 732 und 733 dahingehend überprüft werden, ob eine Betätigung des entsprechenden Annäherungsschalters durch einen Benutzer vorliegt.

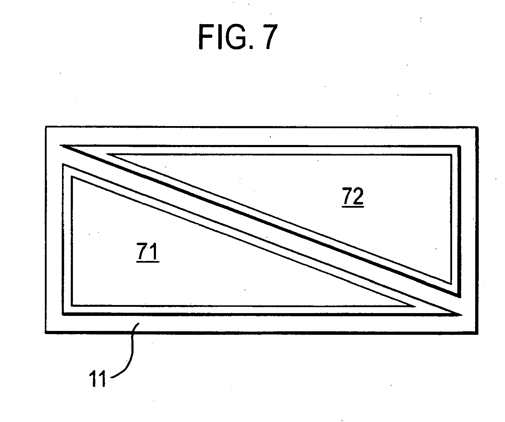

In Figur 7 ist in einer schematischen Vorderansicht eine Ausführungsform zweier Sensorflächen 71 und 72 gezeigt, die zusammen einen Positionssensor bilden. Die Sensorflächen 71 und 72 sind in Form rechtwinkliger Dreiecke ausgebildet und benachbart auf einem gemeinsamen Träger 5 oder auf der Rückseite der Blende 2 angeordnet, wobei sich die Sensorflächen 71 und 72 mit ihrer jeweiligen Hypotenuse gegenüberliegen. Die Sensorflächen 71 und 72 sind von einer gemeinsame Abschirmfläche 11 umrahmt, die sich zwischen den Sensorflächen 71, 72 entlang der Hypotenuse der Dreiecke erstreckt. Je nachdem an welcher Position relativ zu der lateralen Ausdehnung der Sensorflächen 71, 72 eine Betätigung durch den Benutzer erfolgt, indem der Benutzer die Blende 2 im Bereich der Sensorflächen 71, 72 und damit des Positionssensors berührt, ist aufgrund der Dreiecksform der Sensorflächen 71, 72 die Kapazität der mit den Sensorflächen 71, 72 gebildeten Kondensatoren unterschiedlich. Somit kann anhand der den Sensorflächen 71, 72 zugehörigen Ausgangssignale die Position der Betätigung bestimmt und damit ein dieser Position entsprechender bzw. zugeordneter Schaltzustand ausgelöst werden. Bei einer Änderung bzw. Verschiebung der Betätigungsposition, indem beispielsweise der Benutzer seinen Finger auf der Blende 2 verschiebt, wird diese Änderung ebenfalls detektiert und gegebenenfalls ein der neuen Position entsprechender Schaltzustand ausgelöst. Auf diese Weise bildet der Positionssensor einen Schiebeschalter ohne mechanisch zu verschiebende Elemente, durch den beispielsweise eine Temperatur oder eine Leistung bei einem Kochfeld, einem Klimagerät oder einem Kältegerät eingestellt werden kann.

In Figur 8 ist in einer schematischen Schnittansicht ein Ausschnitt des Eingabefeldes gemäß Figur 1 gezeigt. Auf der Leiterplatte 5 ist ein Lötring 7' aufgebrachte, mit dem der durch die unteren zwei Windungen der gewundenen Druckfeder 8 gebildete Windungsteller 9' mit der Leiterplatte 5 verlötet und auf diese Weise mit dem elektrischen Schaltkreis 14 verbunden ist. Die Druckfeder 8 umschließt mit ihren Windungen einen Hohlraum 34. Auf der Leiterplatte 5 sind innerhalb des Lötrings 7' auf der der Abdeckplatte 2 zugewandten Seite von den elektronischen Bauteilen des elektrischen Schaltkreises 14 der PNP-Bipolartransistor des Halbleiterschalters 18, mit seinem Basis-Emitter-Widerstand 23 und seinem Strombegrenzungswiderstand 20 sowie eine Leuchtdiode 35 angeordnet, die in den von der Druckfeder 8 umschlossenen Hohlraum 34 ragen. Um eine elektrische Verbindung dieser elektronischen Bauteile mit den weiteren Bauteilen des elektrischen Schaltkreises 14 zu ermöglichen, ist der Lötring 7' kein gänzlich geschlossener Ring, sondern seitlich unterbrochen (nicht gezeigt). Alternativ dazu kann die elektrische Verbindung auch durch die Leiterplatte 5 hindurch erfolgen. Zusammen mit der auf der Rückseite der Leiterplatte 5 angeordneten Abschirmfläche 11 bildet die Druckfeder 8 einen Faradaykäfig für die im Innenbereich 34 der Druckfeder 8 angeordneten elektronischen Bauteile, so dass diese gegenüber elektromagnetischen Feldern der Umgebung abgeschirmt sind.

Ausgehend von dem Windungsteller 9' weist die Druckfeder 8 einen zylindrischen Teilbereich 36 auf, bei dem der Windungsdurchmesser konstant ist. Daran schließt sich in Richtung von der Leiterplatte 5 zu der Abdeckplatte 2 ein Teilbereich in Form eines Kegelstumpfes 37 an, bei dem der Windungsdurchmesser in Richtung zu der Abdeckplatte hin abnimmt. Auf diese Weise sind die elektronischen Bauteile auch gegenüber elektromagnetischen bzw. kapazitiven Störsignalen aus Richtung der Abdeckplatte abgeschirmt. Insgesamt ist die Druckfeder 8 einstückig aus metallischem Federdraht gewickelt. Es ist aber auch möglich die Druckfeder 8 aus anderen elektrisch leitfähigen Materialien, wie beispielsweise elektrisch leitfähigem Kunststoff oder Kunststoff mit metallischer Seele, in Form eines Kunststoffspritzlings herzustellen. Es ist auch möglich als elektrisch leitfähigen Körper anstelle der Druckfeder einen in sich elastischen Vollkörper aus leitfähigen Kunststoff zu verwenden (nicht gezeigt), der an seinem der Leiterplatte 5 zugewandten Ende eine Höhlung oder eine durchgängige Bohrung zur Aufnahme der elektronischen Bauteile aufweist.

### Bezugszeichenliste

- 1: Haushaltsgerät
- 2: Blende
- 3: Eingabefeld
- 4: Annäherungsschalter
- 5: Leiterplatte
- 6: Rückseite der Blende
- 7: Sensorfläche
- 7': Lötring
- 8: Druckfeder
- 9: Windungsteller der oberen Windungen
- 9': Windungsteller der unteren Windungen
- 10: Referenzsensorfläche
- 11: Abschirmfläche
- 12: Elektronikmodul
- 13: Platine
- 14: Schaltkreis des Annäherungsschalters
- 15: Leistungselektronik
- 16: Finger des Benutzers
- 17: Kondensator
- 18: Halbleiterschalter
- 19: Steuereingang des Halbleiterschalters
- 20: Strombegrenzungswiderstand
- 21: Signaleingang des Halbleiterschalters
- 22: Signalausgang des Halbleiterschalters
- 23: Basis-Emitter-Widerstand
- 24: Sample and Hold-Stufe
- 25: Analoger Signalausgang des Mikroprozessors
- 26: Mikroprozessor
- 27: Analoger Signaleingang des Mikroprozessors
- 28: Taktsignal
- 29: Widerstand
- 30: Niederohmiger Widerstand
- 31: Schalter
- 32: Steuersignaleingang des Schalters
- 33: Steuersignalausgang des Mikroprozessors
- 34: von der Druckfeder umschlossener Hohlraum
- 35: Leuchtdiode
- 36: zylindrischer Teilbereich der Druckfeder
- 37: Teilbereich der Druckfeder in Form eines Kegelstumpfes

## Patentansprüche

1. Kapazitiver Annäherungsschalter mit einer von einer elektrisch isolierenden Abdeckplatte (2) abgedeckten elektrisch leitenden Sensorfläche (7) als Teil eines Kondensators (17) mit durch Annäherung veränderlicher Kapazität, mit einer zugehörigen Auswerteschaltung, und mit einem elektrisch leitfähigen Körper (8), über den die Sensorfläche (7) mit der Auswerteschaltung verbunden ist, und der zwischen der elektrisch isolierenden Abdeckplatte (2) und einem in einem Abstand von dieser angeordneten Träger (5) angeordnet ist, **dadurch gekennzeichnet, dass** auf dem Träger (5) zumindest ein elektronisches Bauelement (18, 20, 23) der Auswerteschaltung derart angeordnet ist, dass es in einen Hohlraum ragt, der von dem elektrisch leitfähigen Körper (8) umgeben ist.

2. Annäherungsschalter nach Anspruch 1, **dadurch gekennzeichnet, dass** das Bauelement (18, 20, 23) der Auswerteschaltung ein aktives Bauelement ist.

3. Annäherungsschalter nach Anspruch 2, **dadurch gekennzeichnet, dass** das aktive Bauelement ein Schaltelement ist.

4. Annäherungsschalter nach einem der Ansprüche 1 bis 3, **dadurch gekennzeichnet, dass** der elektrisch leitfähige Körper (8) mit seinem der Abdeckplatte (2) abgewandten unteren Ende an einem elektrisch leitfähigen Kontakt (7') des Trägers (5) anliegt und über den elektrisch leitfähigen Kontakt (7') mit der Auswerteschaltung verbunden ist.

5. Annäherungsschalter nach einem der vorhergehenden Ansprüche, **dadurch gekennzeichnet, dass** der elektrisch leitfähige Körper (8) mit seinem der Abdeckplatte (2) zugewandten oberen Ende an der Unterseite (6) der Abdeckplatte (2) anliegt und zumindest mit einem Teil seiner Oberfläche zumindest einen Teil der Sensorfläche (7) bildet.

6. Annäherungsschalter nach einem der vorhergehenden Ansprüche, **dadurch gekennzeichnet, dass** auf der dem elektrisch leitfähigen Körper (8) abgewandten Rückseite des Trägers (5) zumindest im Bereich des elektrisch leitfähigen Körpers (8) eine Abschirmfläche (11) angeordnet ist.

7. Annäherungsschalter nach einem der vorhergehenden Ansprüche, **dadurch gekennzeichnet, dass** der elektrisch leitfähige Körper (8) eine aus einem gestreckten Körper gewundene Druckfeder ist.

8. Annäherungsschalter nach Anspruch 7, **dadurch gekennzeichnet, dass** die Druckfeder an ihrem dem Träger zugewandten Ende zumindest in einem Teilbereich (36) zylindrisch geformt ist.

9. Annäherungsschalter nach Anspruch 8, **dadurch gekennzeichnet, dass** die Druckfeder anschließend an den zylindrischen Teilbereich an seinem dem Träger abgewandten Ende einen kegelig geformten Teilbereich (37) aufweist.

10. Annäherungsschalter nach einem der Ansprüche 1 bis 6, **dadurch gekennzeichnet, dass** der elektrisch leitfähige Körper (8) ein in sich elastischer Hohlkörper ist.

11. Eingabefeld für ein Haushaltsgerät mit zumindest einem Annäherungsschalter (4) nach einem der Ansprüche 1 bis 10.

12. Haushaltsgerät mit einem Eingabefeld nach Anspruch 11.

## Claims

1. Capacitive proximity switch with an electrically conductive sensor surface (7), which is covered by an electrically insulating cover plate (2), as part of a capacitor (17) with a capacitance variable by a proximity, with an associated evaluating circuit, and with an electrically conductive body (8) by way of which the sensor surface (7) is connected with the evaluating circuit and which is arranged between the electrically insulating cover plate (2) and a support (5) arranged at a spacing therefrom, **characterised in that** at least one electronic component (18, 20, 23) of the evaluating circuit is so arranged on the support (5) that it protrudes into a cavity surrounded by the electrically conductive body (8).

2. Proximity switch according to claim 9, **characterised in that** the component (18, 20, 23) of the evaluating circuit is an active component.

3. Proximity switch according to claim 2, **characterised in that** the active component is a switching element.

4. Proximity switch according to any one of claims 1 to 3, **characterised in that** the electrically conductive body (8) bears by its lower end, which is remote from the cover plate (2), against an electrically conductive contact (7') of the support (5) and is connected with the evaluating circuit by way of the electrically conductive contact (7').

5. Proximity switch according to any one of the preceding claims, **characterised in that** the electrically conductive body (8) bears by its upper end, which faces the cover plate (2), against the underside (6) of the cover plate (2) and forms, by at least a part of its surface at least a part of the sensor surface (7).

6. Proximity switch according to any one of the preceding claims, **characterised in that** a screening surface (11) is arranged on the rear side, which is remote from the electrically conductive body (8), of the support (5) at least in the region of the electrically conductive body (8).

7. Proximity switch according to any one of the preceding claims, **characterised in that** the electrically conductive body (8) is a compression spring wound from a stretched body.

8. Proximity switch according to claim 7, **characterised in that** the compression spring is formed to be cylindrical at least in a sub-region (36) at its end facing the support.

9. Proximity switch according to claim 8, **characterised in that** the compression spring has at its end remote from the support a conically shaped sub-region (37) connected with the cylindrical sub-region.

10. Proximity switch according to any one of claims 1 to 6, **characterised in that** the electrically conductive body (8) is an intrinsically resilient hollow body.

11. Input field for a domestic appliance with at least one proximity switch (4) according to any one of claims 1 to 10.

12. Domestic appliance with an input field according to claim 11.

## Revendications

1. Détecteur de proximité capacitif comprenant une surface de capteur électroconductrice (7) recouverte par une plaque de recouvrement (2) isolant électriquement, en tant que partie d'un condensateur (17) à capacité se modifiant par approche, comprenant un circuit d'évaluation correspondant, et comprenant un corps électroconducteur (8), par l'intermédiaire duquel la surface de capteur (7) est raccordée au circuit d'évaluation, et qui est disposé entre la plaque de recouvrement (2) isolant électriquement et un support (5) disposé à une distance de celui-ci, **caractérisé en ce qu'**au moins un composant électronique (18, 20, 23) du circuit d'évaluation est disposé sur le support (5) de manière à ce qu'il dépasse dans un espace creux qui est entouré par le corps électroconducteur (8).

2. Détecteur de proximité selon la revendication 1, **caractérisé en ce que** le composant (18, 20, 23) du circuit d'évaluation est un composant actif.

3. Détecteur de proximité selon la revendication 2, **caractérisé en ce que** le composant actif est un élément de commutation.

4. Détecteur de proximité selon l'une quelconque des revendications 1 à 3, **caractérisé en ce que** le corps électroconducteur (8), avec son extrémité inférieure détournée de la plaque de recouvrement (2), est adjacent à un contact électroconducteur (7') du support (5) et **en ce qu'**il est raccordé au circuit d'évaluation par l'intermédiaire du contact électroconducteur (7').

5. Détecteur de proximité selon l'une quelconque des revendications précédentes, **caractérisé en ce que** le corps électroconducteur (8), avec son extrémité supérieure tournée vers la plaque de recouvrement (2), est adjacent au côté inférieur (6) de la plaque de recouvrement (2) et **en ce qu'**il forme au moins une partie de la surface de capteur (7) au moins avec une partie de sa surface.

6. Détecteur de proximité selon l'une quelconque des revendications précédentes, **caractérisé en ce qu'**une surface de blindage (11) est disposée sur le côté arrière du support (5), détourné du corps électroconducteur (8), au moins dans la zone du corps électroconducteur (8).

7. Détecteur de proximité selon l'une quelconque des revendications précédentes, **caractérisé en ce que** le corps électroconducteur (8) est un ressort de compression tordu à partir d'un corps allongé.

8. Détecteur de proximité selon la revendication 7, **caractérisé en ce que** le ressort de compression, sur son extrémité tournée vers le support, est formé de manière cylindrique, tout du moins dans une zone partielle (36).

9. Détecteur de proximité selon la revendication 8, **caractérisé en ce que** le ressort de compression, suite à la zone partielle cylindrique, présente une zone partielle (37) formée de manière conique sur son extrémité détournée du support.

10. Détecteur de proximité selon l'une quelconque des revendications 1 à 6, **caractérisé en ce que** le corps électroconducteur (8) est un corps creux élastique en soi.

11. Champ de saisie pour un appareil électroménager comprenant au moins un détecteur de proximité (4) selon l'une quelconque des revendications 1 à 10.

12. Appareil électroménager comprenant un champ de saisie selon la revendication 11.
